# EUROPEAN PATENT APPLICATION

(11) **EP 0 849 738 A2**
(43) Date of publication of application: **24.06.1998**
(21) Application number: 97310338.5
(22) Date of filing: 19.12.1997
(51) Int. Cl.: G11C 5/00

(54) **Improvements in or relating to electronic systems**

(30) Priority: 19.12.1996 US 33510 P
(71) Applicant: Texas Instruments Incorporated, Dallas, Texas 75265 (US)
(72) Inventor: Vogley, Wilbur C., Missouri City, TX 77459 (US)
(74) Representative: Holt, Michael

(57) **Abstract**

A memory module (10) is provided tha has an outer shield (12) forming an outer perimeter of the memory module (10). A board (14) is positioned inside the outer shield (12) and is coextensive with the outer shield (12) to define an outer portion and an inner portion of the memory module (10). A plurality of memory devices (16) are connected to the board (14) and are positioned in the outer portion between the outer shield (12) and the board (14). The board (14) is operable to communicate information to and from the memory devices (16). An interface connection (22) is positioned in the inner portion and is operable to communicate information to and from the memory module (10). A first interface driver (18) is connected between the interface connection and the board to communicate information from the interface connection (22) to the board (14). A second interface driver (20) is connected between the interface connection (22) and the board (14) to communicate information from the board (14) to the interface connection (22) . A power distribution strip (24) is positioned in the inner portion and connected to the board (14) to provide power to the board (14). A plurality of the memory modules (10) can be stacked to form a memory tower (50).

## Description

### TECHNICAL FIELD OF THE INVENTION

This invention relates in general to the field of electronic systems, and more particularly to a memory module for high speed and high density systems.

### BACKGROUND OF THE INVENTION

Computer and other electronic systems have increasingly large demands for system memory. This is especially true for high performance processors and parallel processing system architectures. Electronic systems are contemplated to include in excess of several gigabytes of main memory, such as DRAM memory, to support their processors and software applications. Providing the required memory space for such systems creates problems with addressing speed, density, power dissipation, power distribution, interconnection, interface and physical space. Some conventional methods for addressing problems produced by large memory space include RAMBUS, which is a single bus architecture providing communication between large numbers of memory devices. However, the RAMBUS scheme is limited in bandwidth and has a high overhead which renders RAMBUS unable to use the peak available bus data transfer rate.

### SUMMARY OF THE INVENTION

In accordance with the present invention, a memory module for high speed and high density systems is provided that substantially reduces or eliminates problems and disadvantages of prior memory modules.

According to one embodiment of the present invention, a memory module is provided that has an outer shield forming an outer perimeter of the memory module. A board is positioned inside the outer shield and is coextensive with the outer shield to define an outer portion and an inner portion of the memory module. A plurality of memory devices are connected to the board and are positioned in the outer portion between the outer shield and the board. The board is operable to communicate information to and from the memory devices. An interface connection is positioned in the inner portion and is operable to communicate information to and from the memory module. A first interface driver is connected between the interface connection and the board to communicate information from the interface connection to the board. A second interface driver is connected between the interface connection and the board to communicate information from the board to the interface connection. A power distribution strip is positioned in the inner portion and connected to the board to provide power to the board. According to one aspect of the present invention, a plurality of these memory modules can be stacked to form a memory tower.

A technical advantage of the present invention is the provision of a memory module subsystem that supplies data at high bandwidth needed by high performance systems with low physical latency.

### BRIEF DESCRIPTION OF THE DRAWINGS

The present invention will now be further described by way of example, with reference to the accompanying drawings in which:
FIGURE 1 is a block diagram of an embodiment of a memory module constructed according to the teachings of the present invention;
FIGURE 2 is a block diagram of another embodiment of a memory module constructed according to the teachings of the present invention;
FIGURE 3 is a block diagram of a further embodiment of a memory module constructed according to the teachings of the present invention; and
FIGURE 4 is a block diagram of an embodiment of a tower assembly of a plurality of memory modules according to the teachings of the present invention.

### DETAILED DESCRIPTION OF THE INVENTION

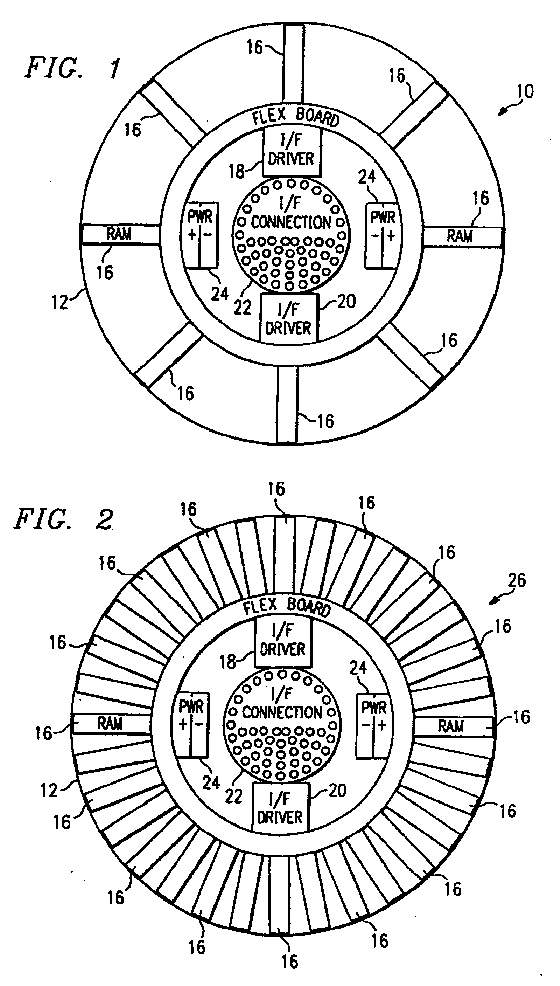

FIGURE 1 is a block diagram of a memory module, indicated generally at 10. Memory module 10 includes an outer shield 12 and a flex board 14 which form a container for a plurality of memory devices 16. Outer shield 12 can also form a boundary for a cooling container in which air or fluid is passed between memory devices 16. As shown, a plurality of memory devices 16 are connected to flex board 14 which is in turn connected to an interface (I/F) driver 18 and an interface driver 20. Interface driver 18 and interface driver 20 are connected to an interface connection 22. It is preferred that interface connection 22 comprises an optical fiber for carrying information to and from memory module 10. Interface driver 18 operates to communicate information from interface connection 22 to flex board 14 and to appropriate memory devices 16. Conversely, interface driver 20 operates to communicate information from memory devices 16 through flex board 14 and to interface connection 22. Memory module 10 further includes power distribution strips 24 which provide power to flex board 14.

In operation, memory module 10 provides an interface to memory devices 16 through flex board 14, interface driver 18, interface driver 20 and interface connection 22. At high operating speeds, the distribution of signals and clocks to the various memory devices 16 can utilize a phase locked loop or other suitable synchronization scheme.

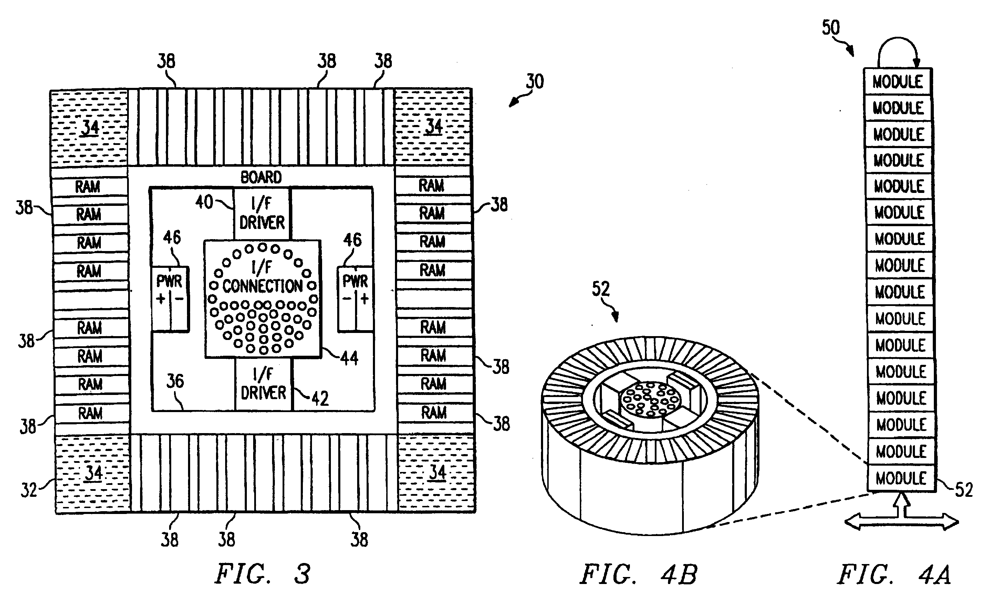

In general, the memory devices, such as SDRAMS, are mounted around an interface driver using a flexible optical cable. At 100 MHz, the base shift between the memory devices can be less than around 400 picoseconds, so no need for clock or data shifts exist. At speeds of 500 MHz, a phase locked loop clock distribution can be used. The data, for example, can be multiplexed at the interface driver. Then, using a gallium arsenic (GaAs) laser drive to an optical interface specified, for example, by the small computer interface (SCI) standard, data can be passed from one memory module to the next in a uni-directional interface. The location of the memory devices within the memory module can allow for a plurality of memory devices to be placed around a single interface driver. The memory modules can then be stacked in a tower, as shown in FIGURE 4, similar to three-dimensional packaging concepts. These stacks can be a number of memory modules deep. The memory modules can be mounted, for example, end-to-end with the last memory module in a tower having a terminator where the terminator simply redirects the optical path through a second fiber passing through the memory modules. As mentioned, the memory modules can have laminated flat power buses along the interior of the memory module that also act as part of the power dissipation surface. The memory towers can also be enclosed to facilitate forced air or liquid cooling. The memory towers may be coupled together either in series or in parallel with a single or separate controller. These memory modules provide advantages in addressing problems with speed, density, power dissipation, power distribution, interconnection, interface and physical space.

FIGURE 2 is a block diagram of another embodiment of a memory module, indicated generally at 26. As shown, memory module 26 is similar to that of FIGURE 1 and includes outer shield 12, flex board 14, and a plurality of memory devices 16. Memory module 26 also includes interface driver 18, interface driver 20 and interface connections 22. In addition, memory module 26 includes power distribution strips 24. These pieces operate to provide access to memory devices 16 in the same manner as the embodiment of FIGURE 1. The difference between memory module 26 at FIGURE 2 and memory module 10 at FIGURE 1 is that memory module 26 has a larger number of memory devices 16. It should be understood, however, that memory modules can be constructed that have varied numbers of memory devices 16 as are suitable for the desired application.

FIGURE 3 is a block diagram of a further embodiment of a memory module, indicated generally at 30. Memory module 30 has a substantially square shape which, in some circumstances, can be produced at lower cost than the circular shapes shown in FIGURE 1 and FIGURE 2. Memory module 30 includes an outer shield 32 which, in part, defines a plurality of cooling regions at the corners of the memory module 30. A board 36 defines an inner surface to which a plurality of memory devices 38 are connected. Similar to the embodiments described above, air or other fluids can be passed between memory devices 38 and through cooling regions 34 in order to dissipate heat within the structure. An interface driver 40 and an interface driver 42 are connected to board 36 and are also connected to an interface connection 44. It is preferred that interface connection 44 comprises an optical fiber for communicating information to and from memory module 30. Interface driver 40 provides communication of information from interface connection 44 to board 36 and to appropriate memory devices 38. Interface driver 42 provides communication of information from memory devices 38 and memory board 36 to interface connection 44. Memory module 30 further includes power distribution strips 46 for providing power to board 36 and memory devices 38.

FIGURES 4A and 4B show a block diagram of an embodiment of a tower assembly of memory modules, indicated generally at 50. Memory tower assembly 50 includes a plurality of separate memory modules 52 stacked upon and connected to each other. Each memory module 52 is constructed having a unidirectional internal memory communication interface with optical fiber. The optical fiber then runs through all of memory modules 52 and is terminated by returning the signal back down through memory modules 52. Memory modules 52 then communicate along a memory bus with remaining portions of the computer system. This memory tower module assembly 50 allows a relatively small physical area to contain a large amount of main memory. For example an area of 22 inches by 22 inches by 4 inches could contain 512 gigabytes of main memory.

Although certain embodiments have been described in detail, it should be understood that various changes, substitutions and alterations can be made thereto without departing from the spirit and scope of the teachings disclosed herein.

## Claims

1. A memory module, comprising:
an outer shield forming an outer perimeter of the memory module;
a board disposed substantially within the outer shield, the board coextensive with the outer shield and defining an outer portion and an inner portion of the memory module;
a plurality of memory devices coupled to the board and disposed in the outer portion between the outer shield and the board, the board operable for communicating information to and from the memory devices;
an interface disposed in the inner portion, and operable for communicating information to and from the memory module;
a first interface driver connected between the interface and the board, and operable for communicating information from the interface connection to the board;
a second interface driver connected between the interface and the board, and operable for communicating information from the board to the interface connection; and
a power distribution strip disposed in the inner portion and coupled to the board, and operable for providing power to the board.

2. The memory module of Claim 1, wherein the interface comprises an optical fiber.

3. The memory module of Claim 1 or Claim 2, wherein the outer shield comprises a substantially cylindrical shape, and the board comprises a flex board having a substantially cylindrical shape.

4. The memory module of Claim 1 or Claim 2, wherein the outer shield and the board are substantially rectangular in shape.

5. The memory module of any of Claims 1 to 4, wherein the interface is coupled to a second memory module to form a memory tower.

6. The memory module of any of Claims 1 to 5, further comprising:
means for circulating air through the outer portion of the memory module for cooling the memory module.

7. The memory module of any of Claims 1 to 5, further comprising:
circulating a cooling fluid through the outer portion of the memory module for cooling the memory module.

8. The memory module of any of Claims 1 to 7, wherein at least one of the plurality of memory modules is a DRAM modules.

9. The memory module of any of Claims 1 to 8, wherein at least one of the plurality of memory modules is an SDRAM modules.

10. A memory tower, having a plurality of memory modules, each memory module comprising:
an outer shield forming an outer perimeter of the memory module;
a board disposed substantially within the outer shield, the board coextensive with the outer shield and defining an outer portion and an inner portion of the memory module;
a plurality of memory devices coupled to the board and disposed in the outer portion between the outer shield and the board, the board operable for communicating information to and from the memory devices;
an interface disposed in the inner portion, and operable for communicating information to and from the memory module;
a first interface driver coupled between the interface connection and the board, the first interface driver operable for communicating information from the interface to the board;
a second interface driver coupled between the interface and the board, the second interface driver operable for communicating information from the board to the interface; and
a power distribution strip disposed in the inner portion and coupled to the board, the power distribution strip operable for providing power to the board; and
wherein the interface connection of each memory module is coupled to the interface of adjacent memory modules, a first memory module looped back to itself forming a communication path through the memory tower that is unidirectional.

11. The memory tower of Claim 10, wherein the interface of each memory module comprises an optical fiber.

12. A method for constructing a memory module, comprising:
forming a container for memory devices by positioning a board substantially within and coextensive with an outer shield, the container having an inner portion and an outer portion;
coupling a plurality of memory devices to the board and positioning the memory devices in the outer portion, the board being operable for communicating information to and from the memory devices;
positioning an interface in the inner portion, the interface connection being operable for communicating information to and from the memory module;
coupling a first interface driver between the interface and the board, the first interface driver operable for communicating information from the interface connection to the board;
coupling a second interface driver between the interface connection and the board, the second interface driver being operable for communicating information from the board to the interface connection; and
positioning a power distribution strip in the inner portion, the power distribution strip coupled to the board and operable for providing power thereto.

13. The method of Claim 12, further comprising:
forming connection from an optical fiber.

14. The method of Claim 12 or Claim 13, wherein the step of forming the container comprises forming the outer shield in a substantially cylindrical shape, and forming the board in a substantially cylindrical shape.

15. The method of Claim 12 or Claim 13, wherein the step of forming the container comprises forming the outer shield and the board in a substantially rectangular shape.

16. The method of any of Claims 12 to 15, further comprising coupling the. interface to a second memory module to form a memory tower.

17. The method of any of Claims 12 to 16, further comprising circulating air through the outer portion of the memory module to cool the memory module.

18. The method of any of Claims 12 to 17, further comprising circulating a cooling fluid through the outer portion of the memory module to cool the memory module.

19. The method of any of Claims 12 to 18, wherein the step of coupling plurality of memory modules comprise coupling at least one DRAM module to the board.

20. The method of any of Claims 12 to 19, wherein the step of coupling the plurality of memory modules comprise coupling at least one SDRAM module to the board.
